# EUROPEAN PATENT SPECIFICATION

(11) **EP 2 315 216 B1**
(45) Date of publication and mention of the grant of the patent: **06.06.2012**
(21) Application number: 10180077.9
(22) Date of filing: 27.09.2010
(51) Int. Cl.: H01B 1/22, C09D 5/24

(54) **Electrically conductive paste, solar cell containing same and method**
Elektrisch leitfähige Paste, Solarzelle damit und Verfahren
Pâte électriquement conductrice, cellule solaire la contenant et procédé

(30) Priority: 30.09.2009 CN 200910190565
(43) Date of publication of application: 27.04.2011
(73) Proprietor: Byd Company Limited, Shenzhen 518118 (CN)
(72) Inventor: Tan, Weihua, 518118, Shenzhen (CN); Liu, Zhen, 518118, Shenzhen (CN); Zhou, Yong, 518118, Shenzhen (CN); Jiang, Zhanfeng, 518118, Shenzhen (CN)
(74) Representative: HOFFMANN EITLE

(56) References cited:
- EP-A1- 0 713 930
- US-A- 5 882 549
- US-A1- 2008 113 195
- DATABASE WPI Week 200405 Thomson Scientific, London, GB; AN 2004-046194 XP002618940, & JP 2003 100145 A (NITTO DENKO CORP) 4 April 2003 (2003-04-04)

## Description

### CROSS-REFERENCE TO RELATED APPLICATION

The present application claims priority to and the benefit of Chinese Patent Application No. 200910190565.X, filed with the State Intellectual Property Office of the People's Republic of China (SIPO) on September 30, 2009, the entire content of which is hereby incorporated by reference.

### FIELD

The disclosure relates to a solar cell, more particularly to an electrically conductive paste for a solar cell, and a method for preparing the same.

### BACKGROUND

Solar energy has been widely used. Silicon-based solar cells are usually made by printing an electrically conductive paste onto a silicon substrate, drying and firing the paste. Conductive pastes have a great impact on the performance of solar cells. At present, organic solvent carrier systems have been widely used for preparing conductive pastes. Nevertheless, the organic solvent may cause environmental pollutions and be harmful to human body. Furthermore, the cost of the organic solvent is relatively high.

### SUMMARY

In one aspect of the present invention, an electrically conductive paste for a solar cell comprises a metal powder, an inorganic adhesive, an aqueous adhesive and an auxiliary agent. The aqueous adhesive comprises a water-soluble polymer selected from cellulose ethers, starch derivatives and combinations thereof.

In another aspect, a solar cell comprises a silicon substrate and an electrically conductive material on the surface of the silicon substrate, wherein the electrically conductive material comprises the paste as defined above.

In yet another aspect, a method of preparing the electrically conductive paste comprises the steps of: mixing a water-soluble polymer selected from cellulose ethers, starch derivatives and combinations thereof, with water to provide an aqueous adhesive; and mixing the aqueous adhesive with an inorganic adhesive, a metal powder and an auxiliary agent to provide an electrically conductive paste.

### DETAILED DESCRIPTION

It will be appreciated by those of ordinary skill in the art that the disclosure may be embodied in other specific forms without departing from the spirit or essential character thereof. The presently disclosed embodiments are therefore considered in all respects to be illustrative and not restrictive.

Unless expressly specified otherwise, the term "comprising" is used in the context of the present application to indicate that further members may optionally be present in addition to the members of the list introduced by "comprising". It is, however, contemplated as a specific embodiment of the present invention that the term "comprising" encompasses the possibility of no further members being present, i.e. for the purpose of this embodiment "comprising" is to be understood as having the meaning of "consisting of".

The following detailed description discloses specific and/or preferred variants of the individual features of the invention. The present invention also contemplates as particularly preferred embodiments those embodiments, which are generated by combining two or more of the specific and/or preferred variants described for two or more of the features of the present invention.

An electrically conductive paste for solar cells comprises a metal powder, an inorganic adhesive, an aqueous adhesive that includes a water-soluble polymer, and an auxiliary agent. In one embodiment, based on the total weight of the conductive paste, the amount of the metal powder is from about 60 wt % to about 85 wt %, the amount of the inorganic adhesive is from about 0.5 wt % to about 10 wt %, the amount of the aqueous adhesive is from about 10 wt % to about 30 wt %, and the amount of the auxiliary agent is from about 0.05 wt % to about 5 wt %.

The water-soluble polymer is selected from the group consisting of cellulose ethers , starch derivatives and combinations thereof. In one instance, the starch derivative is selected from the group consisting of sodium carboxymethyl starch, pregelatinized starches, modified hydroxyethyl starches, quaternary ammonium cation starches, amphoteric starches, and combinations thereof. In another instance, the cellulose ether is selected from the group consisting of sodium carboxymethylcellulose, hydroxypropyl methylcellulose, hydroxyethylcellulose, methylcellulose, and combinations thereof.

In some embodiments, the concentration of the water-soluble polymer can be from about 0.1 wt % to about 20 wt %, based on the total weight of the aqueous adhesive. In one example, it can be about 0.5 wt % to about 8 wt %.

In one embodiment, the auxiliary agent is selected from the group consisting of an anti-sedimentation agent, a surfactant, a water-soluble rheology control agent, and combinations thereof. In the present disclosure, the auxiliary agent may enhance the structure of the conductive paste and provide a good appearance of the silicon film of solar cells.

In one embodiment, the anti-sedimentation agent is selected from the group consisting of hydrophilic fumed silica, organobentonite, diatomite, and combinations thereof. The anti-sedimentation agent may avoid the sedimentation of the conductive paste.

In another emobidment, the surfactant is a fluorocarbon surfactant. For example, commercially available Fluorad FC-4430, FC-4432, or Zonyl^{®}FSJ can be used.

In yet another embodiment, the water-soluble rheology control agent is selected from the group consisting of ammonium sulfate, terephthalic acid, furoic acids, and combinations thereof.

In some embodiments, the metal powder is selected from the group consisting of silver powders, aluminum powders, silver coated copper powders, silver coated aluminum powders, and combinations thereof. They can be spherical or flake shape. Preferably, the metal powder has a D50 value of about 0.25 µm to about 8 µm. The value of D50 is the smallest sieve opening through which 50% of the powder passes. More preferably, the D50 value is from about 0.25 µm to about 3 µm.

In some embodiments, the inorganic adhesive is a non-lead glass powder. Preferably, the non-lead glass powder is made from an oxide powder. Preferably, the oxide powder comprises at least two oxides selected from the group consisting of lead oxide, bismuth oxide, boron trioxide, silicon dioxide, calcium oxide, aluminum oxide, zinc oxide, cobalt oxide, magnesium oxide, zirconium oxide, and strontium oxide. Preferably, the oxide powder has a D50 value of from about 0.5 µm to about 8 µm.

A method of preparing the electrically conductive paste comprises the steps of: mixing the water-soluble polymer as defined above with water to provide an aqueous adhesive as defined above; and mixing the inorganic adhesive, the metal powder and the auxiliary agent as defined above to the aqueous adhesive to provide an electrically conductive paste. Preferably, the method further comprises a step of grinding the electrically conductive paste.

Preferably, the water-soluble polymer, the aqueous adhesive, the inorganic adhesive, the metal powder and the auxiliary agent as well as the amounts or concentrations thereof may be as defined in anyone of the specific embodiments mentioned above.

In some embodiments, the method comprises the following steps.

(1) A water-soluble polymer is dissolved in de-ionized water to obtain a mixture. The mixture is heated to about 70°C and stirred uniformly to obtain an aqueous adhesive.

(2) The aqueous adhesive and an inorganic adhesive are stirred uniformly in the stainless tank of a high-speed dispersing machine. A metal powder is added into the tank in two or three portions. An auxiliary agent is added into the tank and the mixture is stirred for 30 to 60 minutes to provide a uniform mixture.

(3) The obtained mixture is grinded by a three-roller mill (0150) for 10- 15 times to obtain a conductive paste for solar cells.

The paste of the present disclosure may be environment-amicable, may have excellent thixotropy and good construction performance, and may not leak through screen on standing; the cost of the solvent materials may be low; and after long-term storage, may no sedimentation and agglomeration of the finished conductive paste will occur.

Hereinafter, the invention will be described in details with reference to the following embodiments.

### EMBODIMENT 1

(1) Preparation of an Aqueous Adhesive

Sodium carboxymethylcellulose (CMC) is dissolved in de-ionized water to obtain a mixture. The weight ratio of the sodium carboxymethylcellulose to the water is about (2:98). The mixture is heated to about 70°C and stirred uniformly to obtain the aqueous adhesive A1.

(2) Preparation of an Inorganic Adhesive

Bismuth oxide, boron trioxide, silicon dioxide, zinc oxide and aluminum oxide are mixed in a V-type mixer for about 20 minutes to obtain a mixed oxide powder. The weight ratio of the bismuth oxide: boron trioxide: silicon dioxide: zinc oxide: aluminum oxide is about 65: 20: 8: 6: 1. The mixed oxide powder is placed in an oven at about 500°C for 0.5 hour. Then the temperature is increased to 1250°C and maintained for 1 hour. Then the mixed oxide powder is quenched by water and dried until the water content is less than 8%. The obtained mixture is crushed by a crusher, and then is ball-milled at a speed of 100 minute for about 48 hours. The weight ratio of the mill balls (zirconia ball): the mixture: de-ionized water is about 2: 1: 0.5. The mixture is filtered and dried to obtain a glass powder with D₅₀ of about 3.5 µm.

(3) Preparation of a Conductive Paste

The aqueous adhesive A1 and the glass powder are stirred in a stainless tank of a high-speed dispersing machine for 30 minutes at 500 r/minute. A spherical aluminum powder (Yuanyang Co., HeNan, China; D₅₀= 3 µm) is added into the tank in two portions and the mixture is stirred for 60 minutes. A fluorocarbon surfactant Fluorad FC-4430 (3M Co.) and hydrophilic fumed silica are added into the tank and stirred at 1500 r/minute for 30 minutes. The weight ratio of the aqueous adhesive A1: glass powder: aluminum powder: fluorocarbon surfactant: hydrophilic fumed silica is about 23: 2.5: 74.1: 0.1: 0.3. The obtained mixture is milled by a three-roller mill (Ø150) for 10 times to obtain the conductive paste S1 for solar cells. The fineness of the paste is less than 25 µm, measured by a fineness gauge.

### EMBODIMENT 2

(1) Preparation of an Aqueous Adhesive

Sodium carboxymethylcellulose (CMC) is dissolved in de-ionized water to obtain a mixture. The weight ratio of the sodium carboxymethylcellulose to the water is about 5: 95. The mixture is heated to about 70°C and stirred uniformly to obtain the aqueous adhesive A2.

(2) Preparation of an Inorganic Adhesive

Lead oxide, boron trioxide, silicon dioxide, zinc oxide, aluminum oxide and cobalt oxide are mixed by a V-type for about 20 minutes to obtain a mixed oxide powder. The weight ratio of the lead oxide: boron trioxide: silicon dioxide: zinc oxide: aluminum oxide: cobalt oxide is about 65: 13: 9: 4.5: 8: 0.5. The mixed oxide powder is placed in an oven at 500°C for 0.5 hour. The temperature is increased to 1300°C and maintained for 1 hour. The mixed oxide powder is quenched by water and dried until the water content is less than 6%. The obtained mixture is crushed by a crusher, and then is ball-milled at 150 r/minute for about 48 hours. The weight ratio of the mill balls (zirconia ball): mixture: de-ionized water is about 2: 1.5: 0.5. The mixture is filtered and dried to obtain a glass powder with D₅₀ of about 2.5 µm.

(3) Preparation of a Conductive Paste

The aqueous adhesive A2 and the glass powder are stirred in a stainless tank of a high-speed dispersing machine for 30 minutes at 500 r/minute. A flake silver powder (Kunming Research Institute of Precious Metals, China; D₅₀= 2- 3 µm) is added into the tank in two portions and the mixture is stirred for 60 minutes. A fluorocarbon surfactant Fluorad FC-4430 (3M Co.) and organobentonite are added into the tank and the mixture is stirred at 1500 r/minute for 30 minutes. The weight ratio of the aqueous adhesive A2: glass powder: silver powder: fluorocarbon surfactant: organobentonite is about 18.5: 5: 76.2: 0.1: 0.2. The obtained mixture is milled by a three-roller mill (0150) for 12 times to obtain the conductive paste S2 for solar cells. The fineness of the paste is less than 15 µm, measured by a fineness gauge.

### EMBODIMENT 3

(1) Preparation of an Aqueous Adhesive

A hydroxyethylcellulose (HEC) is dissolved in de-ionized water to obtain a mixture. The weight ratio of the sodium carboxymethylcellulose to the water is about 6: 94. The mixture is heated to about 75°C and stirred uniformly to obtain the aqueous adhesive A3.

(2) Preparation of an Inorganic Adhesive

Lead oxide, boron trioxide, silicon dioxide and zinc oxide are placed in a V-type mixer for about 60 minutes to obtain a mixed oxide powder. The weight ratio of the lead oxide: boron trioxide: silicon dioxide: zinc oxide is about 78: 8: 8: 6.

(3) Preparation of a Conductive Paste

The aqueous adhesive A3 and the mixed oxide powder are placed into a stainless tank of a high-speed dispersing machine and stirred for 30 minutes at 500 r/minute. A spherical silver powder (Kunming Research Institute of Precious Metals, China; D₅₀= 2- 3 µm) is added into the tank in two portions and the mixture is stirred for 60 minutes. A fluorocarbon surfactant Fluorad FC-4430 (3M Co.), a water-soluble rheology control agent containing ammonium sulfate powders and hydrophilic fumed silica are added into the tank and stirred at 1500 r/min for 30 minutes. The weight ratio of the aqueous adhesive A3: mixed oxide powder: silver powder: fluorocarbon surfactant: ammonium sulfate powder: hydrophilic fumed silica is about 18.8: 5.2: 75.5: 0.1: 0.2: 0.2. The obtained mixture is milled by a three-roller mill (Ø150) for 12 times to obtain the conductive paste S3 for solar cells. Its fineness is less than 15 µm, measured by a fineness gauge.

### EMBODIMENT 4

The EMBODIMENT 4 is substantially similar to EMBODIMENT 3, with the exception that the sodium carboxymethyl starch (CMS) is used instead of the hydroxyethylcellulose (HEC) in step (1).

The conductive paste is S4.

TESTING

(1) Viscosity of Conductive Paste

Using the method of GB/T17473.5-1998, the viscosities of conductive pastes S1- S4 are tested at 25°C by NDJ-79 Rotary Viscometer at 75 rad/minute. The results are recorded in Table 1.

(2) Storage Stability of Conductive Pastes

The conductive pastes S1- S4 are storage at 25°C in a closed container for 3 months. Their viscosities are tested. They are observed whether any settlement has occurred. The results are recorded in Table 1.

(3) Retention of Pastes on a Mesh Screen

The conductive pastes S1- S4 are disposed onto a 280 mesh metal screen for about 2 hours, with a thickness of about 5 to 8 mm. The paste that passes through the mesh screen is weighted. The weight of less than 5 g is considered as no leaking. The weight of between 5 g to 15 g is considered as slight leaking. The weight of more than 15 g is considered as severe leaking. The results are recorded in Table 1.

(4) Appearance and Adhesion Force of Pastes

The conductive pastes S1- S4 are screen printed onto an aluminum film. Then, the film is heated. They are observed by naked eye to determine whether there are any dents, wrinkles, peeling, ripples and other undesired appearances.

The heated aluminum films are immersed into water at 25°C for 7 days. They are observed by naked eye to determine whether the pastes are peeling off.

The results are recorded in Table 1.

(5) Photoelectric Conversion Efficiency

The conductive pastes S1- S4 are used on monocrystalline silicon wafers. The monocrystalline silicon wafer has a size of about 125x125 mm, a thickness of about 200 µm before the corrosion, and a thickness of about 180 µm before the printing. The mesh has about 280 mesh for aluminum pastes and about 325 mesh for silver pastes. The weight of the aluminum paste coated on the back surface of the silicon wafer is about 1.0 g. The weight of the silver paste on the back surface of the silicon wafer is about 0.10 g. The weight of the silver paste on the light-receiving surface of the silicon wafer is about 0.15 g. The printed wafer is dried at a temperature of about 70 to 100°C. After the light-receiving surface is printed, the monocrystalline silicon wafer is fired in a tunnel furnace at a temperature of about 810 to 930°C. The temperature is distributed in a gradient. The firing time is about 2 minutes, and the time at the peak firing temperature is about 2 seconds.

When preparing the solar cell, the present pastes S1-S4 are used on one surface of the silicon wafer. Pastes on the other surfaces of the silicon wafer are selected from the products of Ferro Co. For example, #53102 aluminum paste, #3347 silver paste for the back- surface, and #33462 silver paste for the light-receiving surface are used.

The photoelectric conversion efficiency of the solar cell wafers is measured by a single-flash simulator. The testing conditions include a light intensity of about 1000 W/m², a spectrum Am1.5 and a temperature of about 25°C.

The results are recorded in Table 1.

**Table 1**

| | Viscosity (mPas) | Viscosity after 3 Months (mPas); Storage Stability | Retention of Pastes on Mesh Screens | Appearance; Adhesion Force of Coating | Photoelectric Conversion Efficiency |
|---|---|---|---|---|---|
| S1 | 38000 | 54000; no settlement | no leaking | Good appearance; no peeling off | 17.87% |
| S2 | 68000 | 87000; no settlement | no leaking | Good appearance; no peeling off | 17.84% |
| S3 | 72000 | 89000; no settelement | no leaking | Good appearance; no peeling off | 17.85% |
| S4 | 85000 | 98000; no settlement | no leaking | Good appearance; no peeling off | 17.83% |

It can be seen from the results in table 1 that: there may be no leaking through the screen for the paste prepared according to the present disclosure during screen printing. The storage stability of the conductive paste may be high. After storing the finished conductive paste for three months, may no serious settlement of the conductive metal powder occurs. When the paste is coated on wafers of a monocrystalline solar cell, the resulting plate may have a good surface condition, the metal film may have no peeling off, and the monocrystalline cell may have an average photoelectric conversion efficiency of over about 17.80%. Furthermore, the conductive paste for the solar cell as described herein may be environment-amicable with greatly reduced material costs.

## Claims

1. An electrically conductive paste for a solar cell comprising:
a metal powder;
an inorganic adhesive;
an aqueous adhesive comprising a water-soluble polymer; and
an auxiliary agent,
wherein the water-soluble polymer is selected from cellulose ethers, starch derivatives, and combinations thereof.

2. The paste of claim 1, wherein the amount of the metal powder is from 60 wt % to 85 wt %, the amount of the inorganic adhesive is from 0.5 wt % to 10 wt %, the amount of the aqueous adhesive is from 10 wt % to 30 wt %, and the amount of the auxiliary agent is from 0.05 wt % to 5 wt %.

3. The paste of claim 1, wherein the cellulose ether is selected from the group consisting of sodium carboxymethylcellulose, hydroxypropyl methylcellulose, hydroxyelhylcellulose, methylcellulose, and combinations thereof.

4. The paste of claim 1, wherein the starch derivative is selected from the group consisting of sodium carboxymethyl starch, pregelatinized starches, modified hydroxyethyl starches, quaternary ammonium cation starches, amphoteric starches, and combinations thereof.

5. The paste of anyone of the preceding claims, wherein the concentration of the water-soluble polymer is from 0.1 wt % to 20 wt %, based on the total weight of the aqueous adhesive.

6. The paste of anyone of the preceding claims, wherein the auxiliary agent is selected from the group consisting of an anti-sedimentation agent, a surfactant and a water-soluble rheology control agent.

7. The paste of claim 6, wherein the anti-sedimentation agent is selected from the group consisting of hydrophilic fumed silica, organobentonite, diatomite, and combinations thereof.

8. The paste of claim 6, wherein the surfactant is a fluorocarbon surfactant.

9. The paste of claim 6, wherein the water-soluble rheology control agent is selected from the group consisting of ammonium sulfate, terephthalic acid, furoic acids, and combinations thereof.

10. The paste of anyone of the preceding claims, wherein the metal powder is selected from the group consisting of silver powder, aluminum powder, silver coated copper powder, silver coated aluminum powder, and combinations thereof.

11. The paste of anyone of the preceding claims, wherein the inorganic adhesive is a non-lead glass powder.

12. The paste of claim 11, wherein the non-lead glass powder comprises at least two oxides selected from the group consisting of lead oxide, bismuth oxide, boron trioxide, silicon dioxide, calcium oxide, aluminum oxide, zinc oxide, cobalt oxide, magnesium oxide, zirconium oxide, and strontium oxide.

13. A solar cell, comprising:
a silicon substrate; and
an electrically conductive material on the surface of the silicon substrate;
wherein the electrically conductive material comprises an electrically conductive paste as defined in anyone of claims 1 to 12.

14. A method of preparing an electrically conductive paste as defined in anyone of claims 1 to 12, comprising the steps of:
mixing a water-soluble polymer selected from cellulose ethers, starch derivatives, and combinations thereof with water to provide an aqueous adhesive; and
mixing the aqueous adhesive with an inorganic adhesive, a metal powder and an auxiliary agent to provide an electrically conductive paste.

## Patentansprüche

1. Elektrisch leitfähige Paste für eine Solarzelle, umfassend:
ein Metallpulver;
ein anorganisches Klebemittel;
ein wässriges Klebemittel, umfassend ein wasserlösliches Polymer; und
ein Hilfsmittel,
wobei das wasserlösliche Polymer aus Celluloseethern, Stärkederivaten und Kombinationen davon ausgewählt wird.

2. Paste gemäß Anspruch 1, wobei die Menge an Metallpulver 60 Gew.% bis 85 Gew.% beträgt, die Menge an organischem Klebemittel 0,5 Gew.% bis 10 Gew.% beträgt, die Menge an wässrigem Klebemittel 10 Gew.% bis 30 Gew.% beträgt und die Menge an Hilfsmitteln 0,05 Gew.% bis 5 Gew.% beträgt.

3. Paste gemäß Anspruch 1, wobei der Celluloseether aus der Gruppe ausgewählt wird, die aus Natriumcarboxymethylcellulose, Hydroxypropylmethylcellulose, Hydroxyethylcellulose, Methylcellulose und Kombinationen davon besteht.

4. Paste gemäß Anspruch 1, worin das Stärkederivat aus der Gruppe ausgewählt wird, die aus
Natriumcarboxymethylstärke, Quellstärken, modifizierten Hydroxyethylstärken, Stärken mit quaternärem Ammoniumkation, amphoteren Stärken und Kombinationen davon besteht.

5. Paste gemäß mindestens einem der vorhergehenden Ansprüche, wobei die Konzentration des wasserlöslichen Polymers 0,1 Gew.% bis 20 Gew.%, bezogen auf das Gesamtgewicht des wässrigen Klebemittels, beträgt.

6. Paste gemäß mindestens einem der vorhergehenden Ansprüche, wobei das Hilfsmittel aus der Gruppe ausgewählt wird, die aus einem Antisedimentationsmittel, einem Tensid und einem wasserlöslichen Rheologiesteuerungsmittel besteht.

7. Paste gemäß Anspruch 6, wobei das
Antisedimentationsmittel aus der Gruppe ausgewählt wird, die aus pyrogener Kieselsäure, Organobentonit, Diatomit und Kombinationen davon besteht.

8. Paste gemäß Anspruch 6, wobei das Tensid ein Fluorkohlenstoff-Tensid ist.

9. Paste gemäß Anspruch 6, wobei das wasserlösliche Rheologiesteuerungsmittel aus der Gruppe ausgewählt wird, die aus Ammoniumsulfat, Terephthalsäure, Furancarbonsäuren und Kombinationen davon besteht.

10. Paste gemäß mindestens einem der vorhergehenden Ansprüche, wobei das Metallpulver aus der Gruppe ausgewählt wird, die aus Silberpulver, Aluminiumpulver, silberbeschichtetem Kupferpulver, silberbeschichtetem Aluminiumpulver und Kombinationen davon besteht.

11. Paste gemäß mindestens einem der vorhergehenden Ansprüche, wobei das anorganische Klebemittel ein Nicht-Bleiglaspulver ist.

12. Paste gemäß Anspruch 11, wobei das Nicht-Bleiglaspulver mindestens zwei Oxide umfasst, die aus der Gruppe ausgewählt werden, die aus Bleioxid, Bismutoxid, Bortrioxid, Siliziumoxid, Kalziumoxid, Aluminiumoxid, Zinkoxid, Kobaltoxid, Magnesiumoxid, Zirkoniumoxid und Strontiumoxid besteht.

13. Solarzelle, umfassend:
ein Siliziumsubstrat und
ein elektrisch leitfähiges Material auf der Oberfläche des Siliziumsubstrats, wobei das elektrisch leitfähige Material eine elektrisch leitfähige Paste wie in einem der Ansprüche 1 bis 12 definiert umfasst.

14. Verfahren zur Herstellung einer wie in einem der Ansprüche 1 bis 12 definierten elektrisch leitfähigen Paste, umfassend die folgenden Schritte:
Mischen eines wasserlöslichen Polymers, das aus Celluloseethern, Stärkederivaten und Kombinationen davon ausgewählt wird, mit Wasser zur Bereitstellung eines wässrigen Klebemittels und
Mischen des wässrigen Klebemittels mit einem anorganischen Klebemittel, einem Metallpulver und einem Hilfsmittel zur Bereitstellung einer elektrisch leitfähigen Paste.

## Revendications

1. Pâte électriquement conductrice pour une pile solaire comprenant :
une poudre métallique ;
un adhésif inorganique ;
un adhésif aqueux comprenant un polymère hydrosoluble ; et
un agent auxiliaire,
dans laquelle le polymère hydrosoluble est choisi parmi des éthers de cellulose, des dérivés d'amidon et des combinaisons de ceux-ci.

2. Pâte selon la revendication 1, dans laquelle la quantité de la poudre métallique va de 60 % en poids à 85 % en poids, la quantité de l'adhésif inorganique va de 0.5 % en poids à 10 % en poids, la quantité de l'adhésif aqueux va de 10 % en poids à 30 % en poids, et la quantité de l'agent auxiliaire va de 0,05 % en poids à 5 % en poids.

3. Pâte selon la revendication 1, dans laquelle l'éther de cellulose est choisi dans le groupe constitué par la carboxyméthylcellulose sodique, l'hydroxypropylméthyl cellulose, l'hydroxyéthylcellulose, la méthylcellulose et des combinaisons de celles-ci.

4. Pâte selon la revendication 1, dans laquelle le dérivé d'amidon est choisi dans le groupe constitué par le carboxyméthylamidon sodique, les amidons prégélatinisés, les hydroxyéthylamidons modifiés, les amidons cationiques d'ammonium quaternaire, les amidons amphotériques et des combinaisons de ceux-ci.

5. Pâte selon l'une quelconque des revendications précédentes, dans laquelle la concentration du polymère hydrosoluble va de 0,1 % en poids à 20 % en poids, sur la base du poids total de l'adhésif aqueux.

6. Pâte selon l'une quelconque des revendications précédentes, dans laquelle l'agent auxiliaire est choisi dans le groupe constitué par un agent anti-sédimentation, un tensioactif et un agent rhéologique hydrosoluble.

7. Pâte selon la revendication 6, dans laquelle l'agent anti-sédimentation est choisi dans le groupe constitué par la silice sublimée hydrophile, l'organobentonite, de diatomite, et des combinaisons de celles-ci.

8. Pâte selon la revendication 6, dans laquelle le tensioactif est un tensioactif fluorocarboné.

9. Pâte selon la revendication 6, dans laquelle l'agent rhéologique hydrosoluble est choisi dans le groupe constitué par le sulfate d'ammonium, l'acide téréphtalique, les acides furoïques et des combinaisons de ceux-ci.

10. Pâte selon l'une quelconque des revendications précédentes, dans laquelle la poudre métallique est choisie dans le groupe constitué par la poudre d'argent, la poudre d'aluminium, la poudre de cuivre revêtue d'argent, la poudre d'aluminium revêtue d'argent et des combinaisons de celles-ci.

11. Pâte selon l'une quelconque des revendications précédentes, dans laquelle l'adhésif inorganique est une poudre de verre sans plomb.

12. Pâte selon la revendication 11, dans laquelle la poudre de verre sans plomb comprend au moins deux oxydes choisis dans le groupe constitué par l'oxyde de plomb, l'oxyde de bismuth, le trioxyde de bore, le dioxyde de silicium, l'oxyde de calcium, l'oxyde d'aluminium, l'oxyde de zinc, l'oxyde de cobalt, l'oxyde de magnésium, l'oxyde de zirconium et l'oxyde de strontium.

13. Cellule solaire, comprenant :
un substrat de silicium ; et
un matériau électriquement conducteur sur la surface du substrat de silicium ;
le matériau électriquement conducteur comprenant une pâte électriquement conductrice selon l'une quelconque des revendications 1 à 12.

14. Procédé de préparation d'une pâte électriquement conductrice selon l'une quelconque des revendications 1 à 12, comprenant les étapes consistant à :
mélanger un polymère hydrosoluble choisi parmi les éthers de cellulose, les dérivés d'amidon et des combinaisons de ceux-ci avec de l'eau pour obtenir un adhésif aqueux ; et
mélanger l'adhésif aqueux avec un adhésif inorganique, une poudre métallique et un agent auxiliaire pour obtenir une pâte électriquement conductrice.
